# FASCICULE DE BREVET EUROPEEN

(11) **EP 3 084 974 B1**
(45) Date de publication et mention de la délivrance du brevet: **18.10.2017**
(21) Numéro de dépôt: 14814858.8
(22) Date de dépôt: 17.12.2014
(51) Int. Cl.: H04B 1/717, H04L 25/03, H03B 5/06

(54) **GENERATEUR D'IMPULSIONS UWB MODULEES EN PHASE**
PHASENMODULIERTER UWB IMPULSGEBER
PHASE MODULATED UWB PULSE GENERATOR

(30) Priorité: 18.12.2013 FR 1362884
(43) Date de publication de la demande: 26.10.2016
(73) Titulaire: Commissariat à l'Énergie Atomique et aux Énergies Alternatives, 75015 Paris (FR)
(72) Inventeur: MASSON, Gilles, F-38140 Renage (FR); HAMEAU, Frédéric, F-38250 Saint-nizier Du Moucherotte (FR); OUVRY, Laurent, F-38000 Grenoble (FR)
(74) Mandataire: Priori, Enrico
(86) Numéro de dépôt international: PCT/EP2014/078246
(87) Numéro de publication internationale: WO 2015/091661

(56) Documents cités:
- WO-A1-2011/053243
- US-A1- 2010 177 803
- US-A1- 2010 237 957

## Description

L'invention concerne le domaine des télécommunications ultra large bande (UWB, de l'anglais Ultra Wide Band), et plus particulièrement la communication par impulsions très courtes d'une fréquence porteuse.

A titre indicatif, la communication UWB est réglementée pour des fréquences pouvant aller de 3 à 10,6 GHz, et les gabarits spectraux autorisés sont définis d'une part par les contraintes réglementaires (FCC aux Etats-Unis, ECC en Europe, etc.) et d'autre part par les contraintes normatives (normes IEEE 802.15.4a, IEEE802.15.6, etc.) ou propriétaires. On peut regrouper ces contraintes de gabarits spectraux sous le terme de "spécification" de gabarit. La largeur de bande est d'environ 1 GHz, et la durée des impulsions émises est typiquement de quelques nanosecondes. Plus généralement, un signal UWB est défini comme un signal dont la bande passante à -10dB de la densité spectrale de puissance maximale est supérieure à 500 MHz, ou alternativement dont la bande passante est supérieure à 20% de la fréquence centrale.

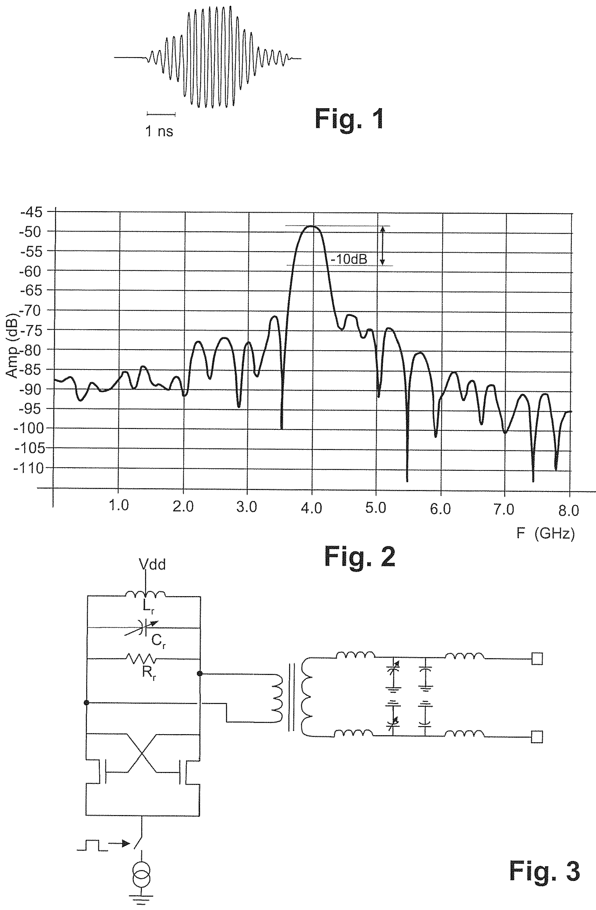

La figure 1 représente à titre d'exemple la forme générale d'une impulsion UWB de 5 nanosecondes ayant une fréquence porteuse de 4 GHz. La figure 2 représente la densité spectrale de puissance de cette impulsion. Ce spectre comporte un pic principal à la fréquence porteuse et une bande passante à -10dB d'environ 500 MHz, mais il comporte aussi de nombreux lobes secondaires dont la fréquence peut être proche de la fréquence porteuse. Ces pics risquent de faire sortir le spectre du gabarit imposé par la spécification, et il faut donc faire en sorte de les réduire autant que possible.

On sait théoriquement utiliser des architectures d'émetteur entièrement numériques qui permettent de bien contrôler le spectre de l'impulsion émise, pour en réduire les lobes secondaires, mais ces architectures sont difficilement compatibles avec des technologies de circuit intégré standard lorsqu'on veut fonctionner avec des fréquences supérieures à 4 GHz, et encore moins à des fréquences de 8 GHz. Ces architectures synthétisent une forme d'onde dans le domaine temporel à la façon d'un filtre numérique fonctionnant à la fréquence de Nyquist. La valeur mais aussi la précision des coefficients du filtre réalisé a un impact direct sur le niveau des lobes secondaires. Cependant, les temps de commutation des transistors des circuits numériques sont trop élevés (au moins 16 GHz pour fonctionner à 8 GHz de fréquence centrale) dans les technologies les plus courantes et il faudrait utiliser des technologies beaucoup plus coûteuses pour résoudre le problème.

Une architecture d'émetteur qui a été proposée pour réaliser des émetteurs d'impulsions UWB dans la bande de 3 à 8 GHz est une architecture dite à oscillateur LC commuté. Cette architecture est intégrable dans les technologies standards (par exemple une technologie MOS à canal de transistor de 130 nanomètres).

Un générateur à oscillateur LC commuté est constitué généralement comme indiqué à la figure 3 : une paire de branches différentielles croisées est montée en oscillateur ; chaque branche comporte un transistor dont la grille est connectée à la sortie de l'autre branche ; les sorties sont prises sur le drain du transistor de la branche ; une charge constituée par un circuit LC, résonant à la fréquence porteuse à émettre, est connectée entre les deux sorties ; la paire différentielle est alimentée en courant par l'intermédiaire d'un commutateur qui autorise ou interdit l'alimentation en courant de la paire. Ce commutateur reçoit une commande logique de mise en conduction qui définit précisément la durée d'application du courant à la paire différentielle, donc la durée de l'impulsion UWB émise sur les sorties.

La charge LC peut être constituée par une capacité variable (pour le réglage de la fréquence d'oscillation) en parallèle sur une inductance. L'inductance et la capacité forment un circuit résonant à la fréquence porteuse souhaitée pour l'impulsion UWB. Une résistance peut être mise en parallèle avec l'inductance et la capacité pour régler le coefficient de surtension de la résonance. Une partie (voire la totalité) de l'inductance de résonance peut être constituée par le primaire d'un transformateur dont le secondaire est relié, éventuellement par l'intermédiaire d'un filtre, à l'antenne d'émission qui doit recevoir l'impulsion UWB.

Pour une communication en modulation de fréquence par exemple, on peut agir sur la valeur de la capacité pour moduler la fréquence d'une impulsion à l'autre. La capacité peut alors être constituée d'une diode varactor ou l'équivalent ; la capacité varie en fonction d'une tension de polarisation appliquée à la diode et la tension de polarisation et la fréquence d'oscillation varie en conséquence. Elle peut être constituée aussi par un réseau de capacités et de commutateurs de sélection.

Pour une communication en modulation d'amplitude, on peut agir sur la valeur du courant d'alimentation de la paire différentielle. Cette valeur définit le sommet de l'enveloppe de variation du niveau de signal au cours de l'impulsion. En modulant la valeur du courant d'alimentation d'une impulsion à la suivante, on module en amplitude l'impulsion émise et cette modulation peut être détectée dans un détecteur.

Mais ce type de générateur d'impulsion ne permet pas de faire facilement une modulation de phase car l'instant de démarrage des oscillations est aléatoire, ce type de d'oscillateur démarrant naturellement sur du bruit.

Les documents suivants décrivent des générateurs d'impulsions UWB:
Raphaeli, et al., Ultra Wideband On-Chip Pulse Generator. Demande de brevet US 2010/0177803 A1, Juillet 2010.
Anh Tuan Phan, et al., Energy-Efficient Low-Complexity CMOS Pulse Generator for Multiband UWB Impulse Radio. IEEE TRANSACTIONS ON CIRCUITS AND SYSTEMS, Vol. 55, NO. 11, December 2008.
Barras, et al., Low-Power Ultra-Wideband Wavelets Generator With Fast Start-Up Circuit. IEEE TRANSACTIONS ON MICROWAVE THEORY AND TECHNIQUES, Vol. 54, NO. 5, May 2006.
Pelissier, et al., A 112Mb/s Full Duplex Remotely-Powered Impulse-UWB RFID Transceiver For Wireless NV-Memory Applications. IEEE JOURNAL OF SOLID-STATE CIRCUITS, Vol. 46, NO. 4, April 2011.

Le document WO 2011/053243 décrit un générateur d'impulsions UWB comprenant : un oscillateur formé par une paire de branches différentielles croisées ayant deux sorties reliées à une charge résonante LC, les branches différentielles étant alimentées par un courant commun commandé par un circuit de commutation de courant qui autorise le passage de courant seulement pendant une durée égale à une durée d'impulsion à émettre ; deux branches d'injection de courant reliées respectivement aux deux sorties ; et un circuit de commande de phase imposant une injection de courant différente dans les deux sorties uniquement pendant une partie de la durée d'impulsion.

L'invention a pour but de réaliser un générateur d'impulsions UWB capable de réaliser très simplement une modulation de phase binaire sans empêcher pour autant d'ajouter, si on le désire, au générateur des moyens de contrôle du spectre de l'impulsion émise par contrôle du courant d'alimentation de l'oscillateur LC commuté. Avantageusement, l'invention vise par ailleurs à assurer le démarrage de l'oscillation avec une phase appropriée, tout en limitant le courant injecté.

Le générateur d'impulsions UWB selon l'invention comprend donc un oscillateur formé par une paire de branches différentielles croisées ayant deux sorties reliées à une charge résonante LC, les branches différentielles étant alimentées par un courant commun commandé par un circuit de commutation de courant qui autorise le passage de courant seulement pendant une durée égale à une durée d'impulsion à émettre, caractérisé en ce qu'il comprend en outre deux branches d'injection de courant reliées respectivement aux deux sorties, et un circuit de commande de phase imposant une injection de courant différente dans les deux sorties avant le début et au moins pendant une première partie de la durée d'impulsion.

Par 'branche d'injection de courant', on entend un circuit qui force le passage d'un courant dans l'inductance du circuit résonant à partir d'une des deux sorties, alors même que les branches différentielles ne sont pas encore normalement alimentées par le courant commun. Le courant injecté d'un côté plus que de l'autre parcourt l'inductance dans un sens ou dans l'autre ; il déséquilibre la paire différentielle et privilégie un sens de démarrage de l'oscillation.

La différence de courants d'injection est obtenue le plus simplement en injectant un courant dans l'une des branches différentielles mais pas dans l'autre. Le rétablissement de la symétrie après la première portion de durée est obtenu le plus simplement en interrompant toute injection de courant dans les deux branches. En pratique, les branches différentielles comportent chacune un transistor et les tensions de grille des transistors sont déséquilibrées par l'injection de courants différents dans les deux sorties.

Ainsi, au début de l'impulsion, les branches différentielles sont déséquilibrées à cause du courant d'injection qui est tiré de l'une des sorties, et une phase de démarrage de l'oscillation est définie en fonction du sens de ce déséquilibre. Deux phases opposées sont possibles selon le sens du déséquilibre puisque c'est soit l'une des branches différentielles soit l'autre qui devient conductrice en premier lorsque le circuit de commutation de courant autorise le passage d'un courant dans la paire de branches différentielles.

Le groupe de deux branches d'injection comprend de préférence une source de courant d'injection commune aux deux branches, et un transistor respectif de sélection de la phase dans chaque branche pour autoriser ou interdire le passage d'un courant dans la branche correspondante. Ce transistor est relié entre la sortie d'une branche différentielle et la source de courant d'injection.

Le circuit de commande de phase qui commande ces transistors reçoit un signal de calage temporel qui définit les instants de début et de fin de l'injection de courant. Ce signal est périodique et a pour période la période d'émission des impulsions UWB. Le circuit de commande de phase reçoit aussi un signal de sélection de phase qui définit pour chaque période la phase (0 ou 180°) de la porteuse de l'impulsion à émettre. Ce circuit de commande fournit des signaux de commande aux grilles des transistors des branches d'injection pour rendre conducteur l'un ou l'autre de ces transistors pendant la première partie de la durée de l'impulsion et pour les bloquer tous les deux après cette première partie.

De préférence, le circuit de commutation de courant est un circuit comprenant plusieurs sources de courant et des commutateurs associés et il est apte à établir successivement plusieurs valeurs de courant différentes à partir du début de l'impulsion et jusqu'à la fin pour donner un profil choisi à l'enveloppe d'amplitude du signal d'oscillation présent sur les sorties de la paire différentielle pendant la durée de l'impulsion.

La charge résonante LC comprend de préférence ou peut même être constituée seulement par le primaire d'un transformateur dont le secondaire est relié, éventuellement par l'intermédiaire d'un filtre, à une antenne d'émission.

Par ailleurs, la charge comprend de préférence une capacité dont la valeur est commandable électroniquement, en fonction d'une fréquence porteuse souhaitée pour l'impulsion UWB à émettre.

D'autres caractéristiques et avantages de l'invention apparaîtront à la lecture de la description détaillée qui suit et qui est faite en référence aux dessins annexés dans lesquels :
- la figure 1, déjà décrite, représente une impulsion UWB avec une fréquence porteuse de 4 GHz, d'une durée d'environ 5 nanosecondes ;
- la figure 2, déjà décrite, représente le spectre de cette impulsion, avec une bande passante à -10dB d'environ 500 MHz ;
- la figure 3, déjà décrite, représente le principe d'un générateur d'impulsion à oscillateur LC commuté ;
- la figure 4 représente un exemple de réalisation du générateur selon l'invention;
- la figure 5 représente un chronogramme de fonctionnement du générateur lors de l'émission d'impulsions UWB modulées en phase d'une manière binaire ;
- la figure 6 représente l'allure du courant dans la paire de branches différentielles dans le cas où ce courant est modulé en amplitude au cours de l'impulsion, pour un meilleur contrôle du spectre.

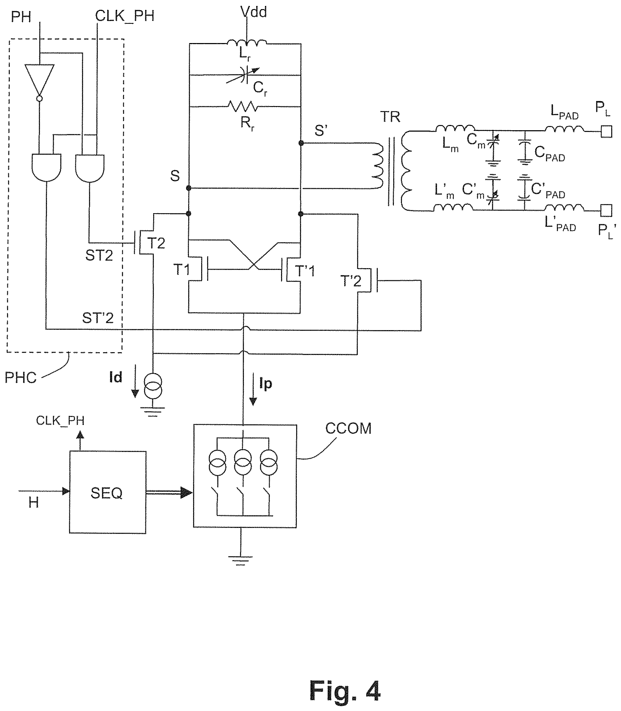

Le générateur d'impulsions UWB de la figure 4 comporte une paire de deux branches différentielles équilibrées alimentées d'un côté par une source de tension d'alimentation Vdd, et de l'autre par un courant commun Ip. Ce courant commun est présent pendant l'impulsion UWB car c'est la présence de ce courant qui permet l'émission de l'impulsion. Il est absent en dehors de l'impulsion. Un séquenceur général SEQ, piloté par une horloge générale H, établit les signaux de commande du circuit de commutation qui met en service le courant Ip avec une période Tp qui peut être définie par un signal d'horloge à l'intérieur du séquenceur SEQ.

Les branches différentielles comportent chacune un transistor, T1 pour la première branche, T'1 pour la deuxième branche. Une charge est insérée entre le drain du transistor et la source de tension d'alimentation Vdd. Cette charge est un circuit LC résonant à la fréquence porteuse F₀ de l'impulsion UWB à émettre. Dans l'exemple représenté, la charge est partagée entre les branches ; elle comprend une inductance Lᵣ et une capacité Cᵣ en parallèle, ainsi qu'une résistance d'amortissement Rᵣ qui peut être la résistance interne propre de l'inductance. Ces éléments en parallèle sont connectés entre la sortie S de la première branche et la sortie S' de la deuxième branche. Les sorties S et S' peuvent être prises sur les drains des transistors respectifs T1 et T'1 de la première et la deuxième branche.

La source de tension d'alimentation est de préférence reliée, comme c'est le cas sur la figure 4, à un point milieu de l'inductance de charge Lᵣ pour assurer l'alimentation continue de l'oscillateur.

L'impulsion UWB est générée entre les sorties S et S'. Ces sorties sont donc connectées à une charge d'utilisation de l'impulsion UWB. Si l'impulsion est destinée à être émise sur une antenne, les sorties sont donc reliées à un circuit de transmission lui-même relié à l'antenne.

Dans l'exemple représenté, le circuit de transmission comprend :
- un transformateur TR dont l'enroulement primaire est connecté entre les sorties S et S' ;
- et un réseau d'adaptation d'impédance relié d'un côté au secondaire du transformateur, et de l'autre à deux plots P_{L} et P'_{L} de connexion extérieure du circuit intégré dans lequel est réalisé le générateur d'impulsions.

Le réseau d'adaptation d'impédance peut comprendre deux inductances Lm et L'm (en principe égales) et deux capacités Cm et C'm (en principe égales) ; les valeurs de ces impédances tiennent compte des impédances propres des plots de connexion extérieur et des connexions reliées à ces plots. Les impédances propres des plots et connexions ont été représentées sous forme d'inductances (en principe égales) L_{PAD} et L'_{PAD} et de capacités (en principe égales) C_{PAD}, C'_{PAD}. L'ensemble des inductances Lm, L'm, L_{PAD}, L'_{PAD}, Cₘ, C'ₘ, C_{PAD}, C'_{PAD} forme le réseau d'adaptation entre le transformateur et la sortie du circuit intégré.

L'inductance de charge Lᵣ du circuit résonant n'est pas obligatoirement présente si l'inductance vue du côté du primaire du transformateur a une valeur suffisante pour remplir le rôle de l'inductance Lᵣ dans le circuit résonant LC. Bien entendu, il faut prévoir alors que la source de tension d'alimentation continue Vdd est reliée à un point milieu du primaire du transformateur pour pouvoir alimenter symétriquement les deux branches différentielles par la tension Vdd.

Les impulsions UWB sont émises pendant un créneau temporel de durée T, pendant lequel la source de courant commun de valeur Ip est mise en service. Elles s'interrompent lorsque le courant est interrompu. Un circuit de commutation CCOM, comprenant au moins une source de courant pour établir la valeur Ip et un commutateur de mise en service ou d'interruption de la source de courant, est placé en série entre le point de jonction des branches différentielles (c'est-à-dire les émetteurs réunis des transistors T1 et T'1) et une masse à potentiel de référence 0. Le circuit de commutation est commandé par le séquenceur général SEQ.

Le circuit oscille à la fréquence de résonance F₀ de la charge de la paire différentielle lorsqu'un courant Ip est appliqué à cette paire différentielle, donc pendant la durée T.

Les impulsions peuvent être émises périodiquement avec une période Tp. Les durées T et Tp sont définies par le séquenceur à partir de l'horloge H.

Un circuit de forçage de phase est prévu pour imposer une phase de démarrage de l'oscillation de la paire différentielle, donc une phase de la fréquence porteuse de l'impulsion UWB. Ce circuit comprend deux branches d'injection de courant reliées l'une à la sortie S et l'autre à la sortie S' et un circuit de commande de phase PHC pour commander ces branches en fonction d'une phase désirée parmi deux phases opposées possibles qu'on désignera arbitrairement par phase 0° et phase 180°.

Le groupe de deux branches d'injection comporte une source de courant d'injection commune aux deux branches réunies à leur base ; les branches d'injection comportent chacune un transistor respectif de sélection de phase T2, T'2 ; la source de courant d'injection tire un courant Id des deux branches de d'injection réunies à leur base par les émetteurs de ces deux transistors. Les transistors T2 et T'2 ne sont pas conducteurs en même temps, de sorte que le courant Id est injecté soit dans la sortie S soit dans la sortie S' selon que c'est le transistor T2 ou le transistor T'2 qui est rendu conducteur. Les transistors T2 et T'2 peuvent être bloqués simultanément lorsqu'on ne veut injecter de courant ni dans la sortie S ni dans la sortie S'. Le courant injecté (-Id) circule dans l'inductance du circuit résonant LC.

Selon la phase désirée au démarrage de l'impulsion UWB, le transistor T2 ou le transistor T'2 est rendu conducteur dès le début de la durée T ou même un peu avant le début de la durée T ; puis ce transistor reste conducteur pendant une première partie de la durée T, et enfin il peut à nouveau être bloqué pendant tout le reste de la durée T et après la fin de la durée T. Le courant Id de la source d'injection est très inférieur à la valeur du courant Ip qui génère l'impulsion UWB. Pour minimiser la consommation, on prévoit que le courant Id est de préférence au moins 20 fois plus faible que la valeur de Ip ou que la valeur du maximum de Ip si Ip varie au cours de l'impulsion UWB. Cette valeur est suffisante pour créer initialement un déséquilibre contrôlé de la paire différentielle T1, T'1. Si le courant Id est très faible, on peut même prévoir qu'il peut rester présent pendant toute la durée de l'impulsion et au delà. S'il est plus important, il est préférable de l'interrompre pendant une deuxième partie de la durée d'impulsion suivant la première partie.

Si c'est le transistor T2 qui est conducteur pendant la première partie de la durée T, c'est le transistor T1 qui tendra à conduire initialement lors du démarrage de l'oscillation. Si au contraire c'est le transistor T'2 qui est conducteur pendant la première partie de la durée T, c'est le transistor T'1 qui tendra à conduire initialement plus que le transistor T1 lors du démarrage de l'oscillation. La phase de démarrage sera donc inversée selon le côté à partir duquel on injecte un courant (-Id). Cette phase initiale se conserve ensuite pendant toute l'impulsion UWB, même s'il n'y a plus d'injection de courant après le début de l'impulsion.

Le circuit de commande de phase PHC établit donc initialement un signal de commande de mise en conduction ST2 sur la grille du transistor T2 ou un signal de commande ST'2 sur la grille du transistor T'2 selon la phase désirée.

Le signal de commande ST2 et le signal de commande ST'2 commencent au début ou juste avant le début de la durée T à partir de laquelle un courant Ip est établi. Il se prolonge du début de la durée T jusqu'à un instant intermédiaire entre le début et la fin de la durée T. Ces signaux ST2 et ST'2 sont établis à partir d'un signal de calage temporel périodique CLK_PH issu du séquenceur SEQ. Le signal CLK_PH est un signal logique qui définit à chaque période le début et la fin de la mise en service d'un courant d'injection ; ce signal est appliqué à deux portes ET qui reçoivent l'une un signal logique PH de sélection de phase et l'autre l'inverse PH_B de ce signal PH par l'intermédiaire d'un inverseur. Les sorties des portes ET fournissent les signaux ST2 et ST'2 appliqués aux grilles des transistors T2 et T'2.

Le circuit de commande de phase ne comporte donc qu'un très petit nombre de composants et la précision temporelle de commande de phase est donc très grande : l'erreur de temps qui peut s'établir entre les deux phases opposées n'est due qu'à la disparité de temps de transit qui peut exister dans ce circuit du fait des deux portes ET. On peut considérer que cette disparité reste au-dessous d'une picoseconde. Si on fonctionne à 8 GHz, soit avec une porteuse de période 62,5 picosecondes, l'erreur de temps reste négligeable, alors qu'une disparité temporelle plus importante aurait des conséquences néfastes sur le spectre de l'impulsion ; c'est donc un avantage de cette architecture que quasiment supprimer toute disparité.

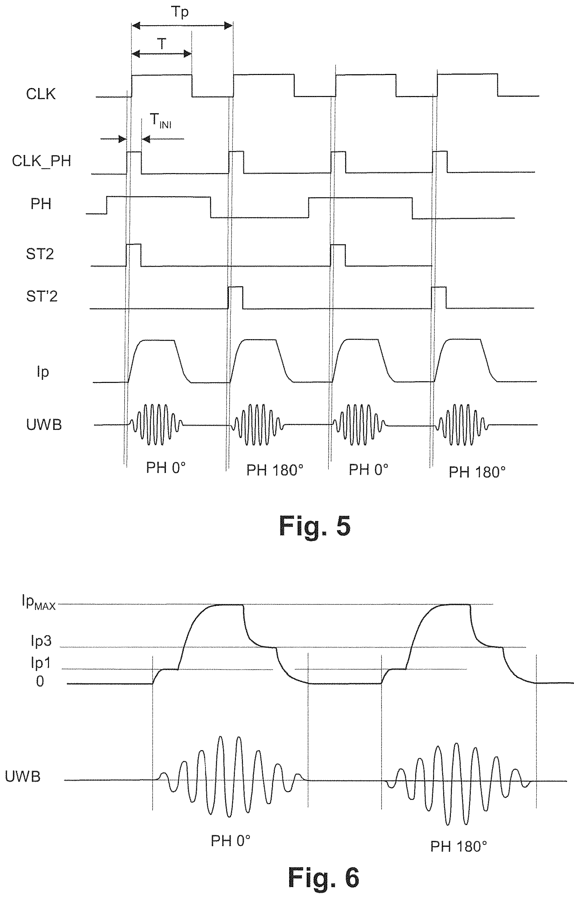

Le chronogramme de la figure 5 représente les signaux de commande de phase et l'impulsion UWB générée, dans un cas simple où la phase est inversée à chaque nouvelle impulsion UWB :
- signal CLK, représentant la périodicité d'émission des impulsions UWB ; CLK est représenté sous forme de créneaux périodiques de durée T et de période Tp, correspondant à la cadence désirée pour l'émission des impulsions UWB ;
- signal de calage temporel CLK_PH de même période Tp et dont la durée T_{INI} définit la durée pendant laquelle les signaux ST2 ou ST'2 doivent être appliqués pendant l'initialisation de l'oscillation ; la durée T_{INI} est de préférence mais pas obligatoirement plus petite ou même beaucoup plus petite que la durée T des impulsions UWB ; elle commence avant l'instant d'émission de l'impulsion UWB, c'est-à-dire avant l'application d'un courant d'alimentation Ip à la paire différentielle ;
- signal de sélection de phase PH : ici, dans l'exemple représenté sur la figure 5, un signal alterné à chaque période Tp, donc à chaque impulsion UWB, entre deux phases opposées ;
- signal ST2 qui est engendré par une des portes ET pour une des phases seulement ;
- signal ST'2 qui est engendré par l'autre porte ET pour l'autre phase ;
- courant Ip appliqué à la paire différentielle (dans le cas d'un courant Ip établi en un seul échelon) pendant une durée T et avec une période Tp ;
- impulsion UWB avec une phase alternée en accord avec la commande de phase PH alternée.

Etant donné que le contrôle du spectre de l'impulsion UWB est important pour maintenir ce spectre dans le gabarit imposé par la spécification de gabarit, on prévoit de préférence que l'amplitude du courant Ip n'est pas constante pendant la durée T mais est établie par échelons successifs entre la valeur zéro et une valeur maximale et est réduite ensuite par échelons successifs entre la valeur maximale et la valeur zéro. Pour cela, on prévoit que le circuit de commutation de courant CCOM comporte plusieurs sources de courant en parallèle, et des commutateurs actionnés selon une séquence très précise à l'intérieur de la durée T, pour mettre en service successivement un courant croissant par échelons puis décroissant par échelons.

Un exemple de séquence de commutation de courant à quatre valeurs est donné à la figure 6, dans lequel le courant croît par échelons d'une valeur 0 à une valeur Ip1, puis à une valeur Ip_{MAX} supérieure à Ip1, puis décroît à une valeur Ip3 (qui pourrait être égale à Ip1) et revient à zéro.

Les différents courants peuvent être produits par des sources de courant ayant les différentes valeurs Ip1, Ip_{MAX}, Ip3, et/ou par mise en parallèle de plusieurs sources de courant dont les sommes permettent d'obtenir les valeurs désirées.

Comparativement aux architectures de l'art antérieur, on peut noter trois avantages qui permettent de réduire l'erreur de phase qui serait due aux désappariements technologiques:
- le courant injecté pour créer le déséquilibre qui impose la phase est exactement identique pour les deux phases opposées : c'est le courant Id qui est aiguillé d'un côté ou de l'autre mais qui ne change pas de valeur ;
- le courant de contrôle de la phase de démarrage peut être très faible, par exemple 10 microampères, car il est indépendant du courant principal Ip qui engendre l'oscillation ; les transistors de sélection de phase T2 et T'2 sont alors de faible dimension, ce qui induit un faible impact de leur désappariement éventuel ;
- le front de commande du choix de la phase est identique pour les deux phases ; il est issu du front montant du signal CLK_PH ; la sélection de la branche d'injection est réalisée symétriquement dans les deux portes ET avant le transit de ce front de commande ; par conséquent, le seul désappariement technologique subsistant est le désappariement sur le temps de traversée du front dans les portes ET, que l'on peut estimer à 2% du temps de traversée, soit 0,8 picoseconde pour un temps de traversée de 40 picosecondes, ce qui est faible, par exemple par rapport à une spécification qui tolérerait 5% d'erreur d'appariement par rapport à la période de la fréquence porteuse (8GHz).

## Revendications

1. Générateur d'impulsions UWB comprenant : un oscillateur formé par une paire de branches différentielles croisées (T1, T'1) ayant deux sorties (S, S') reliées à une charge résonante LC, les branches différentielles étant alimentées par un courant commun (Ip) commandé par un circuit de commutation de courant (CCOM) qui autorise le passage de courant seulement pendant une durée égale à une durée (T) d'impulsion à émettre ; deux branches d'injection de courant (T2, T'2) reliées respectivement aux deux sorties ; et un circuit de commande de phase (PHC) imposant une injection de courant différente dans les deux sorties ; **caractérisé en ce que** ledit circuit de commande de phase (PHC) est configuré pour imposer ladite injection de courant avant le début et au moins pendant une première partie de la durée d'impulsion.

2. Générateur d'impulsions UWB selon la revendication 1, **caractérisé en ce que** l'injection de courant est nulle dans les deux sorties après la fin de la première partie de la durée d'impulsion.

3. Générateur d'impulsions UWB selon l'une des revendications 1 et 2, **caractérisé en ce que** les deux branches d'injection comprennent une source de courant d'injection commune aux deux branches et un transistor de sélection de phase respectif (T2, T'2) dans chaque branche entre la sortie d'une branche différentielle et la source de courant d'injection.

4. Générateur d'impulsions UWB selon la revendication 3, **caractérisé en ce que** le circuit de commande de phase reçoit un signal de calage temporel (CLK_PH) qui définit les instants de début et de fin de l'injection de courant, avec une période qui est la période d'émission des impulsions UWB, et un signal de sélection de phase (PH), et il fournit des signaux de commande aux transistors des branches de d'injection pour rendre conducteur l'un ou l'autre de ces transistors pendant la première partie de la durée de l'impulsion et les bloquer simultanément après la fin de cette première partie.

5. Générateur d'impulsions UWB selon l'une des revendications 1 à 4, **caractérisé en ce que** le circuit de commutation de courant est un circuit comprenant plusieurs sources de courant et des commutateurs associés et est agencé pour établir successivement plusieurs valeurs de courant différentes à partir du début de l'impulsion et jusqu'à la fin pour donner un profil choisi à l'enveloppe d'amplitude du signal présent sur les sorties de la paire différentielle pendant la durée de l'impulsion.

6. Générateur d'impulsions UWB selon l'une des revendications 1 à 5, **caractérisé en ce que** la charge résonante LC comprend le primaire d'un transformateur dont le secondaire est relié, éventuellement par l'intermédiaire d'un filtre, à une antenne d'émission.

7. Générateur d'impulsions UWB selon l'une des revendications 1 à 6, **caractérisé en ce que** la charge résonante LC comprend une capacité (Cᵣ) dont la valeur est commandable électroniquement, en fonction d'une fréquence porteuse souhaitée pour l'impulsion UWB à émettre.

## Patentansprüche

1. UWB-Impulsgenerator, der umfasst: einen durch ein Paar mit gekreuzten Differentialzweigen (T1, T'1) gebildeten Oszillator mit zwei mit einer Resonanzlast LC verbundenen Ausgängen (S, S'), wobei die Differentialzweige durch einen gemeinsamen Strom (Ip) versorgt werden, der durch eine Stromumschaltschaltung (CCOM) gesteuert wird, die den Stromdurchgang ausschließlich während einer Dauer gleich einer Dauer (T) des auszusendenden Impulses erlaubt; zwei jeweils mit den zwei Ausgängen verbundene Stromeinspeisungszweige (T2, T'2); und einen Phasensteuerstromkreis (PHC), der eine unterschiedliche Stromeinspeisung in die zwei Ausgänge aufzwingt; **dadurch gekennzeichnet, dass** der Phasensteuerstromkreis (PHC) konfiguriert ist, um die Stromeinspeisung vor dem Beginn und mindestens während eines ersten Teils der Impulsdauer aufzuzwingen.

2. UWB-Impulsgenerator nach Anspruch 1, **dadurch gekennzeichnet, dass** die Stromeinspeisung in die zwei Ausgänge nach dem Ende des ersten Teils der Impulsdauer Null ist.

3. UWB-Impulsgenerator nach einem der Ansprüche 1 und 2, **dadurch gekennzeichnet, dass** die zwei Einspeisungszweige eine gemeinsame Einspeisestromquelle für die zwei Zweige und einen jeweiligen Phasenauswahltransistor (T2, T'2) in jedem Zweig zwischen dem Ausgang eines Differentialzweiges und der Einspeisestromquelle aufweisen.

4. UWB-Impulsgenerator nach Anspruch 3, **dadurch gekennzeichnet, dass** der Phasensteuerstromkreis ein zeitliches Kalibriersignal (CLK_PH), das die Zeitpunkte des Beginns und des Endes der Stromeinspeisung mit einer Periode definiert, die die Periode der Übertragung der UWB-Impulse ist, und ein Phasenauswahlsignal (PH) empfängt, und es Steuersignale an die Transistoren der Einspeisezweige liefert, um den einen oder den anderen dieser Transistoren während des ersten Teils der Impulsdauer leitend zu machen und sie gleichzeitig nach dem Ende dieses ersten Teils zu sperren.

5. UWB-Impulsgenerator nach einem der Ansprüche 1 bis 4, **dadurch gekennzeichnet, dass** die Stromumschaltschaltung eine Schaltung ist, die mehrere Stromquellen und zugeordnete Umschalter umfasst und ausgelegt ist, um nacheinander mehrere unterschiedliche Stromwerte ab dem Beginn des Impulses und bis zum Ende zu schaffen, um der Amplitudenhüllkurve des an den Ausgängen des Differentialpaares vorliegenden Signals ein gewähltes Profil während der Impulsdauer zu geben.

6. UWB-Impulsgenerator nach einem der Ansprüche 1 bis 5, **dadurch gekennzeichnet, dass** die Resonanzlast LC die Primärseite eines Transformators aufweist, dessen Sekundärseite, eventuell mit Hilfe eines Filters, mit einer Übertragungsantenne verbunden ist.

7. UWB-Impulsgenerator nach einem der Ansprüche 1 bis 6, **dadurch gekennzeichnet, dass** die Resonanzlast LC einen Kondensator (Cᵣ) aufweist, dessen Wert in Abhängigkeit von einer gewünschten Trägerfrequenz für den auszusendenden UWB-Impuls elektronisch steuerbar ist.

## Claims

1. A UWB pulse generator comprising: an oscillator formed by a pair of intersecting differential branches (T1, T'1) having two outputs (S, S') connected to a resonant load LC, the differential branches being supplied with power by a common current (Ip) controlled by a current switching circuit (CCOM) that allows current to pass through only during a duration equal to a duration (T) of a pulse to be transmitted; two current injection branches (T2, T'2) respectively connected to the two outputs; and a phase control circuit (PHC) imposing a different injection of current into the two outputs; **characterised in that** said phase control circuit (PHC) is configured to impose said injection of current before the start and at least during a first part of the pulse duration.

2. The UWB pulse generator according to claim 1, **characterised in that** the injection of current is zero in the two outputs after the end of the first part of the pulse duration.

3. The UWB pulse generator according to any one of claims 1 and 2, **characterised in that** the two injection branches comprise an injection current source that is common to the two branches and a respective phase selection transistor (T2, T'2) in each branch between the output of a differential branch and the injection current source.

4. The UWB pulse generator according to claim 3, **characterised in that** the phase control circuit receives a timing signal (CLK_PH) that defines the start and end instants of the injection current, with a period that is the transmission period of the UWB pulses, and a phase selection signal (PH), and it feeds control signals to the transistors of the injection branches in order to make one or the other of said transistors conductive during the first part of the duration of the pulse and to simultaneously block them after the end of this first part.

5. The UWB pulse generator according to any one of claims 1 to 4, **characterised in that** the current switching circuit is a circuit comprising a plurality of current sources and associated switches and is arranged to successively establish a plurality of different current values from the start of the pulse and until the end in order to give a selected profile to the amplitude envelope of the signal present on the outputs of the differential pair for the duration of the pulse.

6. The UWB pulse generator according to any one of claims 1 to 5, **characterised in that** the resonant load LC comprises the primary of a transformer, the secondary of which is connected, optionally by means of a filter, to a transmission antenna.

7. The UWB pulse generator according to any one of claims 1 to 6, **characterised in that** the resonant load LC comprises a capacitor (Cᵣ), the value of which is electronically controllable as a function of a desired carrier frequency for the UWB pulse to be transmitted.
